# EUROPÄISCHE PATENTSCHRIFT

(11) **EP 2 950 353 B1**
(45) Veröffentlichungstag und Bekanntmachung des Hinweises auf die Patenterteilung: **10.10.2018**
(21) Anmeldenummer: 14001895.3
(22) Anmeldetag: 30.05.2014
(51) Int. Cl.: H01L 31/054, H01L 31/18

(54) **Solarzelleneinheit**
Solar cell unit
Unité de cellules solaires

(43) Veröffentlichungstag der Anmeldung: 02.12.2015
(73) Patentinhaber: AZUR SPACE Solar Power GmbH, 74072 Heilbronn (DE)
(72) Erfinder: Löckenhoff, Rüdiger, 74321 Bietigheim-Bissingen (DE)
(74) Vertreter: Koch Müller Patentanwaltsgesellschaft mbH

(56) Entgegenhaltungen:
- EP-A1- 2 693 492
- EP-A1- 2 693 493
- EP-A1- 2 693 494
- EP-A1- 2 693 495
- WO-A2-2013/046221
- WO-A2-2014/060404
- US-A1- 2004 041 222
- US-A1- 2009 120 499
- US-A1- 2012 152 309

## Beschreibung

Die Erfindung betrifft eine Solarzelleneinheit und ein Verfahren zur Herstellung einer solchen..

Aus der EP 2 073 279 A1 ist ein Solarzellenmodul bekannt, bei dem ein als Solarzelle ausgebildeter Halbleiterkörper auf einem Träger angeordnet ist. Um den Halbleiterkörper und insbesondere dessen Seitenflächen vor Umgebungseinflüssen zu schützen, die zu einer Degradation der elektrischen Parameter führen, wird um den Halbleiterkörper an drei Selten ein Rahmen angeordnet und mit einem transparenten Deckel abgeschlossen. Anschließend wird der verbleibende Zwischenraum mit einer transparenten Vergussmasse aufgefüllt und ein optisches Element angebracht.
Aus der EP 1 953 825 A2 ist eine weitere Solarzelfeneinheit bekannt. Hierbei wird auf einem Träger ein als Solarzelle ausgebildeter Halbleiterkörper angeordnet. Anschließend werden zum Schutz des Halbleiterkörpers eine Dichtfolie und ein aus mehreren Teilen bestehendes Gehäuse, welches auch ein optisches Element umfasst, in einem mehrstufigen Prozess auf dem Träger angeordnet.
Aus der DE 10 2009 006 286 A1 ist eine Solarzelleneinheit bekannt, welches eine Vielzahl von einzelnen Solarzellen auf einem Träger aufweist. Unter anderem ist oberhalb der Solarzelle ein optisches Element, welches auch als sekundäres optisches Element bezeichnet "SOE" wird, angeordnet. Das optische Element leitet das durch eine Fresnellinse fokussierte Licht der Sonne auf die Oberfläche der Solarzelle. Mittels der fokussierenden Anordnung lassen sich mit wenigen kleinen Solarzellen, welche einen Wirkungsgrad bis zu 40% und darüber aufweisen, großflächige Solarzelleneinheiten aufbauen.

Aus der EP 2 693 493 A1 ist eine Solarzelleneinheit bekannt, welches ein optisches Element und einen Halbleiterkörper aufweist, wobei das optische Element einen Absatz und zwei Justiermarken auf der unteren Fläche des Absatzes aufweist.

Vor diesem Hintergrund besteht die Aufgabe der Erfindung darin, eine Vorrichtung anzugeben, die den Stand der Technik weiterbildet.

Die Aufgabe wird durch eine Solarzelleneinheit mit den Merkmalen des Patentanspruchs 1 und durch ein Verfahren mit den Merkmalen des Patentanspruchs 14 gelöst. Vorteilhafte Ausgestaltungen der Erfindung sind Gegenstand von Unteransprüchen.

Gemäß dem ersten Gegenstand der Erfindung wird eine Solarzelleneinheit bereitgestellt, wobei die Solarzelleneinheit einen als Solarzelle ausgebildeten Halbleiterkörper mit einer Empfangsfläche aufweist, und einen Träger mit einer Oberseite und einer Unterseite aufweist, wobei der Halbleiterkörper mit der Oberseite des Trägers elektrisch verschaltet und kraftschlüssig verbunden ist, und ein mit der Empfangsfläche kraftschlüssig verbundenen transparentes optisches Element aufweist, wobei das optische Element eine Oberfläche aufweist, und wobei ein Teil der Oberfläche als eine im Wesentlichen oder überwiegend konvexe Empfangsfläche ausgebildet ist und mittels der konvexen Empfangsfläche ein auf die Empfangsfläche auftreffendes Sonnenlicht gebündelt, und wobei die Empfangsfläche von einem schulterförmigen Absatz umgeben ist, und wobei der schulterförmige Absatz eine erste Randfläche und eine zweite Randfläche aufweist, und wobei der Normalenvektor der ersten Randfläche und der Normalenvektor der zweiten Randfläche im Wesentlichen oder genau parallel zu der optischen Achse des optischen Elements ausgebildet sind und die Normalenvektoren entgegen der Richtung von dem auftreffenden Sonnenlicht zeigen, und bei dem schulterförmigen Absatz in Verbindung mit der ersten Randfläche eine erste Justiermarke und in Verbindung mit der zweiten Randfläche eine zweite Justiermarke vorgesehen ist, um mittels den beiden Justiermarken das optische Element in Bezug zu der Empfangsfläche der Solarzelle zu positionieren und auszurichten, wobei die erste Justiermarke von der zweiten Justiermarke beabstandet ist, um das auftreffende Sonnenlicht vollständig oder zumindest weitestgehend auf die Empfangsfläche zu leiten. Untersuchungen haben gezeigt, dass es vorteilhaft ist die Justiermarken derart anzuordnen und auszuformen, dass die Position und die Ausrichtung in Bezug zu der Empfangsfläche der Solarzelle eindeutig bestimmt werden.

Gemäß dem zweiten Gegenstand der Erfindung wird ein Verfahren zur Herstellung einer Solarzelleneinheit durch einen Fügeprozess unter Verwendung eines als Solarzelle ausgebildeten Halbleiterkörper bereitgestellt, wobei der Halbleiterkörper eine Empfangsfläche aufweist, und die Solarzelleneinheit einem Träger mit einer Oberseite und einer Unterseite aufweist, und wobei der Halbleiterkörper mit der Oberseite des Trägers elektrisch verschaltet und kraftschlüssig verbunden ist, und die Solarzelleneinheit ein sekundäres optisches Element aufweist, das optische Element von schulterförmigen Absatz umgeben ist, und der schulterförmige Absatz eine erste Randfläche und eine zweite Randfläche aufweist, und wobei der Normalenvektor der ersten Randfläche und der Normalenvektor der zweiten Randfläche im Wesentlichen parallel zu der optischen Achse des optischen Elements ausgebildet sind und die Normalenvektoren entgegen der Richtung von dem auftreffenden Sonnenlicht zeigen, und bei dem schulterförmigen Absatz in Verbindung mit der ersten Randfläche eine erste Justiermarke und in Verbindung mit der zweiten Randfläche eine zweite Justiermarke vorgesehen ist, wobei die erste Justiermarke von der zweiten Justiermarke beabstandet ist, und während des Fügeprozesses das sekundäre optische Element von einer Greifereinheit gehalten wird, und die Position und Ausrichtung des optischen Elements zu der Greifereinheit durch Formschluss der Greifereinheit mit den Justiermarken bestimmt wird, und ein Verbindungsmittel auf die Empfangsfläche und/oder auf die Unterseite des optischen Elementes aufgebracht wird, und das optische Element zu der Empfangsfläche positioniert und ausgerichtet wird, und das optische Element von der Greifereinheit während des Aushärtens des Verbindungsmittels in einem vorgegebenen Abstand zu der Empfangsfläche gehalten wird, um einen mit dem ausgehärteten Verbindungsmittel gefüllten Spalt zwischen dem optischen Element und der Empfangsfläche auszubilden.
Es sei angemerkt, dass das optische Element vorzugsweise aus einer anorganischen Verbindung ausgebildet ist und höchst vorzugsweise transparent wenigstens für einen Wellenlängenbereich von Infrarot bis einschließlich Ultraviolett ist. Vorzugsweise ist das optische Element vollständig aus Quarzglas ausgebildet.

Ein Vorteil der erfindungsgemäßen Vorrichtung ist es, dass das optische Element zu der Empfangsfläche mit dem Halbleiterkörper exakt ausgerichtet und positioniert gefügt wird. Hierdurch lassen sich der Wirkungsgrad und die Zuverlässigkeit der Solarzelleneinheit erhöhen. Untersuchungen haben gezeigt, dass sich mit dem erfindungsgemäßen Verfahren eine automatisierte Herstellung bei einer hohen Ausbeute von großen Stückzahlen durchführen lässt.

In einer Weiterbildung wird vor dem Absetzen des sekundären optischen Elements ein viskoses Verbindungsmittel auf der Oberfläche der Solarzelle aufgebracht. Zwischen dem optischen Element und der Empfangsfläche der Solarzelle ist hierdurch eine UV transparente Klebstoffschicht ausgebildet. Vorteilhaft ist, wenn als viskoses Verbindungsmittel ein transparentes Silikon oder ein transparentes Polyurethan verwendet wird. In einer anderen Weiterbildung wird das Verbindungsmittel mittels einer an der Greifereinheit angeordneten Dispensdüse aufgebracht. Das optische Element wird gemäß einer bevorzugten Ausführungsform von der Greifereinheit mittels eines Vakuumsaugers aufgenommen.

Untersuchungen haben gezeigt, dass das optische Element von der Greifereinheit vor dem Aufbringen des Verbindungsmittels aufgenommen wird. Insbesondere wenn die Greifereinheit eine Dispenseinheit umfasst, lässt sich unmittelbar nach dem Aufbringen des Verbindungsmittels das optische Element mit dem Halbleiterkörper fügen. Mit der Ausbildung der Dispenseinheit an der Greifereinheit wird ein großer Verfahrweg der Greifereinheit vermieden.

In einer besonders bevorzugten Ausführungsform wird das sekundäre optische Element mittels eines Formschluss zwischen der Greifereinheit und einem oder mehreren an dem optischen Element ausgebildeten Justiermittel innerhalb der Greifereinheit positioniert und ausgerichtet. Anders ausgedrückt, das optische Element ist nach dem Aufnehmen durch die Greifereinheit sofort in der Greifereinheit vollständig justiert. Insbesondere wird durch den Formschluss zwischen dem sekundären optischen Element und der Greifereinheit gemäß der Kinematik die Position und Ausrichtung des sekundären optischen Elements in Referenz zur Greifereinheit eindeutig bestimmt. Hierbei wird unter dem Begriff Kinematik die Festlegung der Position des optischen Elements durch drei Koordinaten im dreidimensionalen Raum als auch mittels drei weiteren Freiheitsgrade für die Rotation, d.h. Drehungen im dreidimensionalen Raum zur Beschreibung der Lage des gesamten Körpers verstanden.

In einer Weiterbildung ist eine dritte Justiermarke auf dem Absatz vorgesehen ist, wobei die dritte Justiermarke von der ersten Justiermarke und von der zweiten Justiermarke beanstandet ist. In einer bevorzugten Weiterbildung ist die erste Justiermarke auf der ersten Randfläche und / oder die die zweite Justiermarke auf der zweiten Randfläche und / oder die dritte Justiermarke auf einer dritten Randfläche ausgebildet. In einer Ausführungsform umfasst die die erste Justiermarke und / oder die zweite Justiermarke und / oder die dritte Justiermarke eine Erhebung und oder eine Nut umfasst. Untersuchungen haben gezeigt, dass es vorteilhaft ist, wenn die Justiermarken eine Strukturhöhe von mindestens 0,2 mm gemessen aufweisen. Hierdurch lässt sich eine mechanische Zentrierung und Ausrichtung des optischen Elements besonders einfach und zuverlässig durchführen. In einer vorteilhaften Weiterbildung sind alle Justiermarken als Nuten ausgebildet sind.

In einer Ausführungsform wird die Positionierung des optischen Elements innerhalb der Greifereinheit mittels Kante und / oder Vertiefung und oder Erhöhung an dem optischen Element durchgeführt, d.h. an der Greifereinheit sind jeweils zu den Justiermarken Ausformungen angeordnet, wobei nach der Aufnahme des optischen Elements die Ausformungen wenigstens teilweise einen Formschluss mit den Justiermarken ausbilden.

In einer bevorzugten Weiterbildung schließen die erste Justiermarke, die optische Achse und die zweite Justiermarke einen ersten Winkel ein. Des Weiteren schließen die zweite Justiermarke, die optische Achse und die dritte Justiermarke einen zweiten Winkel ein, wobei der zweite Winkel ungleich zu dem ersten Winkel ist. In einer anderen Weiterbildung beträgt der Winkel zwischen zwei unmittelbar benachbarten Justiermarken 120° oder 135°, wobei die Winkel zwischen Justiermarken jeweils in Bezug zur optischen Achse bestimmt sind. Ferner ist es bevorzugt, dass der Winkel zwischen zwei unmittelbar benachbarten Justiermarken entweder 135° und / oder 90° beträgt, wobei die Winkel zwischen den Justiermarken jeweils in Bezug zur optischen Achse gemessen werden.

In einer anderen Weiterbildung werden der Träger und das sekundäre optische Element derart erwärmt, dass beide Fügepartner während des Fügeprozesses eine Temperatur von mindestens 60°C aufweisen. Ein Vorteil ist, dass sich hierdurch zwischen den beiden Fügepartnern in einer kurzen Zeitspanne eine kraftschlüssige Verbindung ausbilden lässt. Unter einer kurzen Zeitspanne wird ein Fügezeitintervall unterhalb von dreißig Sekunden verstanden. In einer bevorzugten Weiterbildung bleibt das optische Element mit der Greifereinheit wenigstens teilweise vorzugsweise während der gesamten Aushärtezeit des Verbindungsmittels kraftschlüssig miteinander verbunden.

In einer anderen Weiterbildung ist eine dritte Randfläche vorgesehen ist. Es zeigt sich, dass es vorteilhaft ist, den Absatz als einen umlaufenden Rand auszubilden, d. h. der umlaufende Rand das optische umschließt Element vollständig ringförmig. Insbesondere ist es vorteilhaft, die Randflächen als eine zusammenhängende plane Fläche ausbilden. Untersuchungen haben, dass in einer alternativen der Absatz zwei gegenüberliegende zueinander parallele Kanten aufweist.

In einer anderen Ausführungsform wird bei der Erfassung der Position der Solarzelle auch die Ausrichtung erfasst, so dass das sekundäre optische Element in Abhängigkeit von der Ausrichtung der Solarzelle ausgerichtet abgesetzt wird.

Vorteilhaft ist, wenn auf der Oberseite des Randes drei lineare Justiermittel ausgebildet sind, wobei jedes der drei linearen Justiermittel entweder als lineare Kerbe oder als linearer Wall oder als lineare Kante ausgebildet ist und die drei linearen Justiermittel paarweise eine unterschiedliche Ausrichtungen aufweisen. In einer besonders vorteilhaften Weiterbildung weist das optische Element eine plane Unterseite auf, wobei die Fläche der Unterseite vorzugsweise größer ist, als die Empfangsfläche der Solarzelle. Es ist bevorzugt, die plane Unterseite parallel zu der planen Empfangsfläche anzuordnen und bei dem Fügeprozess die Menge des Verbindungsmittels so groß zu wählen, dass die Fläche an der Unterseite des optischen Elements und die Empfangsfläche jeweils vollständig mit dem Verbindungsmittel benetzt sind. Anders ausgedrückt bildet das Verbindungsmittel in dem gefügten Zustand zwischen der Unterseite und der Empfangsfläche eine vorzugsweise blasenfreie Schicht mit einer gleichbleibenden Dicke aus.

Untersuchungen haben gezeigt, dass es vorteilhaft ist, wenn das optische Element eine erste Drehachse aufweist und das optische Element bezüglich der ersten Drehachse eine wenigstens teilweise oder vorzugsweise vollständige rotationsymmetrische Form aufweist. Ferner ist es vorteilhaft, wenn eine erste Raumrichtung durch eine Senkrechte auf der Drehachse durch das Zentrum eines ersten Justiermittels auf dem Rand des sekundären optischen Elements gegeben ist und ferner eine zweite Raumrichtung durch eine erste Solarzellenkante gegeben ist und dass der Ist-Winkel zwischen der ersten Raumrichtung und der zweiten Raumrichtung um maximal 2% von einem Soll-Winkel abweicht.

In einer Weiterbildung wird das optische Element oder der Halbleiterkörper während des Aushärtens des Verbindungsmittels auf einer Temperatur von wenigstens 50°C, vorzugsweise auf einer Temperatur oberhalb 60°C gehalten. Hierbei hält die Greifereinheit das sekundäre optische Element kraftschlüssig im Abstand zur Empfangsfläche des Halbleiterkörpers während bei dem Verbindungsmittel ein Phasenübergang von flüssig zu fest eintritt.

In einer bevorzugten Ausführungsform wird vor der Positionierung und Ausrichtung des sekundären optischen Elements zur Empfangsfläche die Position und Ausrichtung der Empfangsfläche auf dem Träger mit einem Bilderkennungssystem erfasst.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und die lateralen und vertikalen Erstreckungen sind nicht maßstäblich und weisen, sofern nicht anders angegeben auch keine ableitbaren geometrischen Relationen zueinander auf. Darin zeigt:
- Figur 1: eine perspektivische Ansicht auf eine erste Ausführungsform einer Solarzelleneinheit,
- Figur 2a: eine perspektivische Ansicht auf eine zweite Ausführungsform der Solarzelleneinheit,
- Figur 2b: eine Schnittdarstellung auf die zweite Ausführungsform der Solarzelleneinheit,
- Figur 3a: eine detaillierte perspektivische Ansicht auf die erste Ausführungsform der Solarzelleneinheit,
- Figur 3b: eine Schnittdarstellung auf die erste Ausführungsform der Solarzelleneinheit,
- Figur 4: eine perspektivische Darstellung auf eine Greifereinheit, während des Fügeprozesses,
- Figur 5: eine Schnittdarstellung auf eine Konzentratoranordnung.

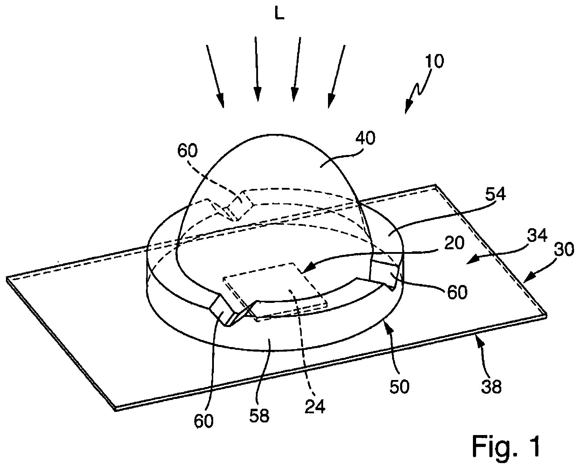

Die Abbildung der Figur 1 zeigt eine perspektivische Ansicht auf eine erste Ausführungsform einer Solarzelleneinheit 10 mit einem als Solarzelle 20 ausgebildeten Halbleiterkörper mit einer Empfangsfläche 24 und einem Träger 30. Der Träger 30 weist eine Oberseite 34 und einer Unterseite 38 auf, wobei der Halbleiterkörper mit der Oberseite 34 des Trägers 30 elektrisch verschaltet - nicht dargestellt - und kraftschlüssig verbunden ist. Der Halbleiterkörper ist von einem sekundären optischen Element 40 abgedeckt, wobei das optische Element 40 eine plane Unterseite 44 aufweist und die plane Unterseite 44 in Richtung der Empfangsfläche 24 zeigt. Auf der Empfangsfläche 24 und zwischen der Empfangsfläche 24 und dem optischen Element 40 ist ein elastisches Verbindungsmittel vorzugsweise ein transparentes Silikon oder ein transparentes Polyurethan aufgebracht. Mittels des Verbindungsmittels ist das optische Element 40 mit der Solarzelle 20 kraftschlüssig verbunden. Aus Gründen der Übersichtlichkeit ist das Verbindungsmittel nicht dargestellt. Die Lichteinstrahlung L, vorzugsweise ein bereits gebündelter Sonnenlichtstrahl, trifft auf die Oberfläche des optischen Elements 40 und wird durch das optische Element 40 weiter fokussiert und auf die Empfangsfläche 24 der Solarzelle 20 geleitet. Die Solarzelle 20 ist vorzugsweise aus mehreren einzelnen Teilzellen stapelförmig aufgebaut, wobei die einzelnen Teilzellen auf einen unterschiedlichen Spektralbereich des Lichtes angepasst sind. Vorzugsweise ist das optische Element 40 einstückig aus Quarzglas oder einer Quarzglasverbindung aufgebaut.

Das optische Element 40 weist einen Rand 50 mit einer Oberseite 54 und einer Seitenfläche 58 auf. Vorliegend ist der Rand 50 als umlaufend dargestellt, wobei der Rand 50 als einstückiger Teil des optischen Elements 40 ausgebildet ist. Die Fläche der Oberseite 54 ist von der Oberseite 34 des Träges 30 abgewandt, anders ausgedrückt die Flächennormale der Oberseite 34 des Trägers 30 und die Flächennormale der Oberseite 54 des Randes 50 weisen im Wesentlichen in die selbe Richtung. An der Oberseite 54 des Randes 50 sind drei als lineare Kerben 60 ausgebildete Justiermittel angeordnet. Hierbei sind die Kerben 60 gleichmäßig von einander beabstandet.

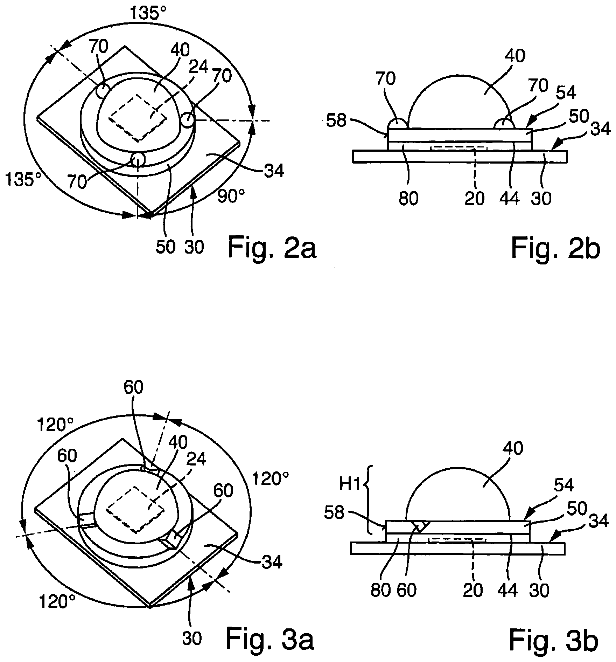

In der Abbildung der Figur 2a ist eine perspektivische Ansicht auf eine zweite Ausführungsform der Solarzelleneinheit 10 und in der Figur 2b eine Schnittdarstellung der zweiten Ausführungsform der Solarzelleneinheit 10 dargestellt. Im Folgenden werden nur die Unterschiede zu der vorangegangenen Ausführungsform erläutert. An der Oberseite 54 des Randes 50 sind drei als kugelförmige Erhöhungen 70 ausgebildete Justiermittel angeordnet. Die drei Erhöhungen 70 sind voneinander beabstandet, wobei zwischen zwei unmittelbar benachbarten Erhöhungen 70 ein Winkel von 90° ausgebildet ist und von den beiden unmittelbar benachbarten Erhöhungen jeweils in Richtung zu der dritten Erhöhung 70 ein Winkel von 135° ausgebildet ist. Es sei angemerkt, dass sich zwischen den Erhöhungen auf dem Rand auch andere Winkelverhältnisse ausbilden lassen. Insbesondere lassen sich die Erhöhungen derart verteilen, dass jeweils zwischen zwei benachbarten Erhöhungen ein Winkel von 120° ausbildet.

Die Schnittdarstellung der Figur 2b zeigt zwischen der Unterseite 44 des optischen Elements 40 und der Empfangsfläche 24 der Solarzelle 20 einerseits und zwischen der Oberseite 34 des Trägers 30 und der Unterseite 44 des optischen Elements 40 andererseits eine Schicht des Verbindungsmittels 80, wobei das Verbindungsmittel 80 auch die Seitenflächen des Halbleiterkörpers d.h. der Solarzelle umschließt und hierdurch vor Umwelteinflüssen schützt.

In der Abbildung der Figur 3a ist eine perspektivische Ansicht auf die erste Ausführungsform der Solarzelleneinheit 10 und in der Figur 3b eine Schnittdarstellung der ersten Ausführungsform der Solarzelleneinheit 10 dargestellt. Im Folgenden werden nur die Unterschiede zu den vorangegangenen Ausführungsformen erläutert. An der Oberseite 54 des Randes 50 sind die drei linearen Kerben 60 angeordnet, wobei die drei Kerben 60 gleichmäßig voneinander beabstandet sind, so dass zwischen zwei unmittelbar benachbarten Kerben 60 jeweils ein Winkel von 120° ausgebildet ist. In der Darstellung der Figur 3b zweit sich, dass das optische Element 40 eine Höhe H1 aufweist, wobei die Höhe H1 wesentlich größer ist als die Summe aus der Höhe des Trägers 30 mit dem aufliegenden Halbleiterkörper. Hierdurch ragt die Kuppel des optischen Elements 40 aus der Ebene des Trägers 30 hinaus.

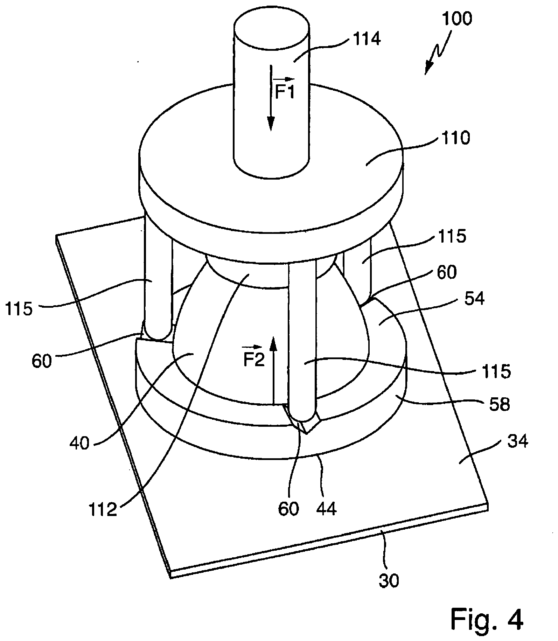

In der Figur 4 ist eine Greifereinheit 100 während des Fügeprozesses dargestellt. Im Folgenden werden nur die Unterschiede zu den vorangegangenen Ausführungsformen erläutert. Die Greifereinheit 100 weist eine kreisrunde tellerförmiger Platte 110 auf. Auf der Oberseite der Platte 100 ist ein zylinderförmiger Stab 114 ausgebildet und mit der Platte 110 starr verbunden. Unterhalb der Platte 110 ist eine Saugglocke 112 ausgebildet. Die Saugglocke 112 weist in dem Mittenbereich einen nicht dargestellten Vakuumanschluss auf. Mittels der Saugglocke 112 ist das optische Element 40 kraftschlüssig mit der Greifereinheit 100 während des Fügeprozesses verbunden. Die Greifereinheit 100 weist drei mit der Platte 110 starr verbundene Zentrierstifte 115 auf, wobei an der Kopfseite der Zentrierstifte 115 halbkugel- oder kegelstumpfförmige Flächen ausgebildet sind. Die Zentrierstifte 115 greifen mit der jeweiligen Kopfseite in die Kerben 60 ein, wobei ein teilweiser Formschluss zwischen der Kopfseite und den Kerben 60 gegeben ist.

Vorliegend drückt die Greifereinheit 100 das optische Element 40 mit einer Kraft F1 auf die Unterlage, d.h. die Unterseite 44 des optischen Elements 40 drückt auf das Verbindungsmittel 80. Hierbei wird die Kraft F1 jedoch so gewählt, dass eine vorgegebene Spaltbreite zwischen der Empfangsfläche 24 und der Unterseite 44 des optischen Elements 40 eingestellt wird. Es versteht sich, dass die gesamte Spaltbreite mit dem Verbindungsmittel 80 ausgefüllt ist. Im dargestellten Gleichgewichtsfall drückt die Träger 30 mit einer Kraft F2 entgegen der Kraft F1 der Greifereinheit 100, wobei vorliegend die beiden Kräfte F1 und F2 entgegengesetzt gleich groß sind. Während des Fügeprozesses sind das optische Element 40 und der Träger 30 auf eine vorgegebene Temperatur von etwa 60°C erwärmt. Das zwischen der Unterseite 44 des optischen Elements 40 und der Empfangsfläche 24 und dem Träger 30 ausgebildete nicht dargestellte Verbindungsmittel 80 ist bei dem Auftragen viskos und weist eine Aushärtezeit auf. Die Greifereinheit 100 drückt wenigstens eines Teils oder während der gesamten Aushärtezeit des Verbindungsmittels 80 das optische Element 40 auf die Unterlage, bestehend aus dem Träger 30 und der aufliegenden Solarzelle 20.

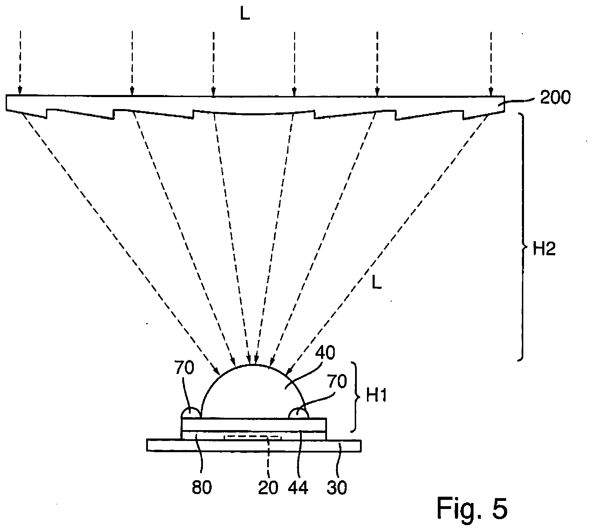

Die Figur 5 zeigt eine Schnittdarstellung auf eine Konzentratoranordnung mit einem als Fresnel Linse ausgebildeten primären optischen Element 200. Die Fresnel Linse ist durch eine Höhe H2 von der Solarzelleneinheit 10 entfernt. Die Höhe H2 ist wesentlich größer als die Höhe H1.

## Patentansprüche

1. Solarzelleneinheit, aufweisend
- einen als Solarzelle (20) ausgebildeten Halbleiterkörper mit einer Empfangsfläche (24), und
- einen Träger (30) mit einer Oberseite (34) und einer Unterseite (38), wobei der Halbleiterkörper mit der Oberseite (34) des Trägers (30) elektrisch verschaltet und kraftschlüssig verbunden ist, und
- ein mit der Empfangsfläche kraftschlüssig verbundenen transparentes sekundäres optisches Element (40), wobei das optische Element (40) eine Oberfläche aufweist, und wobei ein Teil der Oberfläche als eine im Wesentlichen konvexe Empfangsfläche ausgebildet ist und mittels der konvexen Empfangsfläche des optischen Elements (40) ein auf die konvexe Empfangsfläche auftreffendes Sonnenlicht (L) gebündelt wird, und wobei die konvexe Empfangsfläche des optischen Elements (40) von einem schulterförmigen Absatz (50) umgeben ist, und wobei der schulterförmige Absatz (50) eine erste Randfläche und eine zweite Randfläche aufweist, und wobei der Normalenvektor der ersten Randfläche und der Normalenvektor der zweiten Randfläche im Wesentlichen parallel zu der optischen Achse des optischen Elements (40) ausgebildet sind und die Normalenvektoren entgegen der Richtung von dem auftreffenden Sonnenlicht (L) zeigen, und bei dem schulterförmigen Absatz auf der ersten Randfläche eine erste Justiermarke (60; 70) und auf der zweiten Randfläche eine zweite Justiermarke (60; 70) angeordnet ist, um mittels den beiden Justiermarken (60; 70) das optische Element (40) in Bezug zu der Empfangsfläche (24) der Solarzelle (20) zu positionieren und auszurichten, wobei die erste Justiermarke (60; 70) von der zweiten Justiermarke (60; 70) beabstandet ist, um auf das optische Element auftreffendes Sonnenlicht (L) auf die Empfangsfläche (24) der Solarzelle (20) zu leiten.

2. Solarzelleneinheit nach Anspruch 1, **dadurch gekennzeichnet, dass** eine dritte Justiermarke auf einer dritten Randfläche des Absatzes vorgesehen ist, wobei die dritte Justiermarke von der ersten Justiermarke und von der zweiten Justiermarke beanstandet ist.

3. Solarzelleneinheit nach einem der vorangegangenen Ansprüche, **dadurch gekennzeichnet, dass** die erste Justiermarke und / oder die zweite Justiermarke und / oder die dritte Justiermarke eine Erhebung und / oder eine Nut umfasst.

4. Solarzelleneinheit nach einem der vorangegangenen Ansprüche, **dadurch gekennzeichnet, dass** die Justiermarken ein Strukturhöhe von mindestens 0,2 mm gemessen aufweisen, um eine mechanische Zentrierung und Ausrichtung zu ermöglichen.

5. Solarzelleneinheit nach Anspruch 3 oder Anspruch 4, **dadurch gekennzeichnet, dass** jede Justiermarke genau eine Nut umfasst.

6. Solarzelleneinheit nach einem der Ansprüche 2 bis 5, **dadurch gekennzeichnet, dass** die erste Justiermarke, die optische Achse und die zweite Justiermarke einen ersten Winkel einschließen und die zweite Justiermarke, die optische Achse und die dritte Justiermarke einen zweiten Winkel einschließen und der zweite Winkel ungleich dem ersten Winkel ist.

7. Solarzelleneinheit nach einem der vorangegangenen Ansprüche, **dadurch gekennzeichnet, dass** der Winkel zwischen zwei unmittelbar benachbarten Justiermarken 120° oder 135° beträgt, wobei Winkel zwischen Justiermarken jeweils in Bezug zur optischen Achse bestimmt sind.

8. Solarzelleneinheit nach einem der Ansprüche 2 bis 6, **dadurch gekennzeichnet, dass** der Winkel zwei unmittelbar benachbarten Justiermarken 135° und 90° beträgt, wobei Winkel zwischen Justiermarken jeweils in Bezug zur optischen Achse gemessen werden.

9. Solarzelleneinheit nach einem der vorangegangenen Ansprüche, **dadurch gekennzeichnet, dass** eine dritte Randfläche vorgesehen ist.

10. Solarzelleneinheit nach einem der vorangegangenen Ansprüche, **dadurch gekennzeichnet, dass** der Absatz einen umlaufenden Rand ausbildet und der umlaufende Rand das optische Element vollständig ringförmig umschließt.

11. Solarzelleneinheit nach einem der vorangegangenen Ansprüche, **dadurch gekennzeichnet, dass** die Randflächen eine zusammenhängende plane Fläche ausbilden.

12. Solarzelleneinheit nach einem der vorangegangenen Ansprüche, **dadurch gekennzeichnet, dass** zwischen dem optischen Element und der Empfangsfläche der Solarzelle eine UV transparente Klebstoffschicht ausgebildet ist.

13. Verfahren zur Herstellung einer Solarzelleneinheit (10) durch einen Fügeprozess mit
- einem als Solarzelle (20) ausgebildeten Halbleiterkörper mit einer Empfangsfläche (24), und
- einem Träger (30) mit einer Oberseite (34) und einer Unterseite (38), wobei der Halbleiterkörper mit der Oberseite (34) des Trägers (30) elektrisch verschaltet und kraftschlüssig verbunden ist, und
- einem sekundären optischen Element (40), wobei das optische Element eine Oberfläche aufweist, und wobei ein Teil der Oberfläche als eine im Wesentlichen konvexe Empfangsfläche ausgebildet ist und mittels der konvexen Empfangsfläche ein auf die Empfangsfläche auftreffendes Sonnenlicht gebündelt wird,
**dadurch gekennzeichnet, dass**
das optische Element (40) von einem schulterförmigen Absatz (50) umgeben ist, und der schulterförmige Absatz (50) eine erste Randfläche und eine zweite Randfläche aufweist, und wobei der Normalenvektor der ersten Randfläche und der Normalenvektor der zweiten Randfläche im Wesentlichen parallel zu der optischen Achse des optischen Elements (40) ausgebildet sind und die Normalenvektoren entgegen der Richtung von dem auftreffenden Sonnenlicht (L) zeigen, und bei dem schulterförmigen Absatz (50) auf der ersten Randfläche eine erste Justiermarke (60; 70) und auf der zweiten Randfläche eine zweite Justiermarke (60; 70) angeordnet ist, wobei die erste Justiermarke (60; 70) von der zweiten Justiermarke (60;70) beabstandet ist, und während des Fügeprozesses das sekundäre optische Element (40) von einer Greifereinheit (100) gehalten wird, und die Position und Ausrichtung des optischen Elements (40) zu der Greifereinheit (100) durch Formschluss der Greifereinheit mit den Justiermarken bestimmt wird und
ein Verbindungsmittel (80) auf die Empfangsfläche (24) und/oder auf die Unterseite (44) des optischen Elementes (40) aufgebracht wird und
das optische Element (40) zu der Empfangsfläche (24) positioniert und ausgerichtet wird und
das optische Element (40) von der Greifereinheit (100) während des Aushärtens des Verbindungsmittels (80) in einem vorgegebenen Abstand zu der Empfangsfläche (24) gehalten wird
um einen mit dem ausgehärteten Verbindungsmittel (80) gefüllten Spalt zwischen dem optischen Element (40) und der Empfangsfläche (24) auszubilden.

14. Verfahren nach Anspruch 13, **dadurch gekennzeichnet, dass** während des Aushärtens des Verbindungsmittels (80) das optische Element (40) oder der Halbleiterkörper auf einer Temperatur von wenigstens 50°C gehalten wird.

15. Verfahren nach den Ansprüchen 13 oder 14, **dadurch gekennzeichnet, dass** vor der Positionierung und Ausrichtung des sekundären optischen Elements zur Empfangsfläche (24) die Position und Ausrichtung der Empfangsfläche (24) auf dem Träger (40) mit einem Bilderkennungssystem erfasst wird.

## Claims

1. Solar cell unit comprising
- a semiconductor body, which is constructed as a solar cell (20), with a receiving surface (24),
- a carrier (30) with an upper side (34) and a lower side (38), wherein the semiconductor body is electrically connected with and mechanically positively coupled to the upper side (34) of the carrier (30), and
- a transparent secondary optical element (40) mechanically positively connected with the receiving surface, wherein the optical element (40) has a surface, wherein a part of the surface is formed as a substantially convex receiving surface and sunlight (L) incident on the convex surface is focused by means of the convex receiving surface of the optical element (40), wherein the convex receiving surface of the optical element (40) is surrounded by a shoulder-shaped step (50), wherein the shoulder-shaped step (50) has a first edge surface and a second edge surface, and wherein the normal vector of the first edge surface and the normal vector of the second edge surface are formed to be substantially parallel to the optical axis of the optical element (40) and the normal vectors point against the direction from the incident sunlight (L), and in the case of the shoulder-shaped step a first adjusting mark (60; 70) is arranged on the first edge surface and a second adjusting mark (60; 70) is arranged on the second edge surface so as to position and align the optical element (40) with respect to the receiving surface (24) of the solar cell (20) by means of the two adjusting marks (60; 70), wherein the first adjusting mark (60; 70) is spaced from the second adjusting mark (60; 70) so as to conduct sunlight (L) incident on the optical element to the receiving surface (24) of the solar cell (20).

2. Solar cell unit according to claim 1, **characterised in that** a third adjusting mark is provided on a third edge surface of the step, wherein the third adjusting mark is spaced from the first adjusting mark and from the second adjusting mark.

3. Solar cell unit according to one of the preceding claims, **characterised in that** the first adjusting mark and/or the second adjusting mark and/or the third adjusting mark comprises or comprise an elevation and/or a groove.

4. Solar cell unit according to any one of the preceding claims, **characterised in that** the adjusting marks have a structure height of at least 0.2 millimetres as measured so as to enable mechanical centring and orientation.

5. Solar cell unit according to claim 3 or claim 4, **characterised in that** each adjusting mark comprises exactly one groove.

6. Solar cell unit according to any one of claims 2 to 5, **characterised in that** the first adjusting mark, the optical axis and the second adjusting mark include a first angle and the second adjusting mark, the optical axis and the third adjusting mark include a second angle, the second angle being unequal to the first angle.

7. Solar cell unit according to any one of the preceding claims, **characterised in that** the angle between two directly adjacent adjusting marks is 120° or 135°, wherein angles between adjusting marks are each defined with respect to the optical axis.

8. Solar cell unit according to any one of claims 2 to 6, **characterised in that** the angle of two directly adjacent adjusting marks is 135° and 90°, wherein angles between adjusting marks are each measured with respect to the optical axis.

9. Solar cell unit according to any one of the preceding claims, **characterised in that** a third edge surface is provided.

10. Solar cell unit according to any one of the preceding claims, **characterised in that** the step forms an encircling edge and the encircling edge fully annularly encloses the optical element.

11. Solar cell unit according to any one of the preceding claims, **characterised in that** the edge surfaces form a cohesive planar area.

12. Solar cell unit according to any one of the preceding claims, **characterised in that** an adhesive layer transparent to ultraviolet light is formed between the optical element and the receiving surface of the solar cell.

13. Method of producing a solar cell unit (10) by a joining process, with
- a semiconductor body, which is constructed as a solar cell (20), with a receiving surface (24),
- a carrier (30) with an upper side (34) and a lower side (38), wherein the semiconductor body is electrically connected with and mechanically positively coupled to the upper side (34) of the carrier (30), and
- a secondary optical element (40), wherein the optical element has a surface and wherein a part of the surface is formed as a substantially convex receiving surface and sunlight incident on the receiving surface is focused by means of the convex receiving surface, **characterised in that**
the optical element (40) is surrounded by a shoulder-shaped step (50) and the shoulder-shaped step (50) has a first edge surface and a second edge surface, wherein the normal vector of the first edge surface and the normal vector of the second edge surface are formed to be substantially parallel to the optical axis of the optical element (40) and the normal vectors point against the direction from the incident sunlight (L), and in the shoulder-shaped step (50) a first adjusting mark (60; 70) is arranged on the first edge surface and a second adjusting mark (60; 70) is arranged on the second edge surface, wherein the first adjusting mark (60; 70) is spaced from the second adjusting mark (60; 70), and, during the joining process,
the secondary optical element (40) is held by a gripper unit (100) and the position and orientation of the optical element (40) with respect to the gripper unit (100) are determined by mechanically positive coupling of the gripper unit with the adjusting marks and
a connecting means (80) is applied to the receiving surface (40) and/or to the underside (44) of the optical element (40) and
the optical element (40) is positioned and oriented with respect to the receiving surface (24) and
the optical element (40) is held by the gripper unit (100) at a predetermined spacing from the receiving surface (24) during hardening of the connecting means (80) so as to form a gap, which is filled by the hardened connecting means (80), between the optical element (40) and the receiving surface (24).

14. Method according to claim 13, **characterised in that** during hardening of the connecting means (80) the optical element (40) or the semiconductor body is kept at a temperature of at least 50° C.

15. Method according to claim 13 or 14, **characterised in that** prior to positioning and orientation of the secondary optical element with respect to the receiving surface (24) the position and orientation of the receiving surface (24) on the carrier (40) is detected by an image recognition system.

## Revendications

1. Unité de cellules solaires, présentant
- un corps semi-conducteur configuré comme cellule solaire (20) avec une face de réception (24), et
- un support (30) avec un côté supérieur (34) et un côté inférieur (38), dans laquelle le corps semi-conducteur est connecté électriquement et assemblé par adhérence au côté supérieur (34) du support (30), et
- un élément optique secondaire transparent (40) assemblé par adhérence à la face de réception, dans laquelle l'élément optique (40) présente une surface, et dans laquelle une partie de la surface est formée par une face de réception essentiellement convexe et une lumière solaire (L) arrivant sur la face de réception convexe est focalisée au moyen de la face de réception convexe de l'élément optique (40), et dans laquelle la face de réception convexe de l'élément optique (40) est entourée par un rebord en forme d'épaulement (50), et dans laquelle le rebord en forme d'épaulement (50) présente une première face de bord et une deuxième face de bord, et dans laquelle le vecteur normal de la première face de bord et le vecteur normal de la deuxième face de bord sont essentiellement parallèles à l'axe optique de l'élément optique (40) et les vecteurs normaux sont dirigés à l'inverse de la direction de la lumière solaire incidente (L), et près du rebord en forme d'épaulement une première marque d'ajustement (60; 70) est disposée sur la première face de bord et une deuxième marque d'ajustement (60; 70) est disposée sur la deuxième face de bord, afin de positionner et d'orienter l'élément optique (40) par rapport à la face de réception (24) de la cellule solaire (20) au moyen des deux marques d'ajustement (60; 70), dans laquelle la première marque d'ajustement (60; 70) est espacée de la deuxième marque d'ajustement (60; 70), afin de conduire la lumière solaire incidente (L) arrivant sur l'élément optique sur la face de réception (24) de la cellule solaire (20).

2. Unité de cellules solaires selon la revendication 1, **caractérisée en ce qu'**il est prévu une troisième marque d'ajustement sur une troisième face de bord du rebord, dans laquelle la troisième marque d'ajustement est espacée de la première marque d'ajustement et de la deuxième marque d'ajustement.

3. Unité de cellules solaires selon l'une quelconque des revendications précédentes, **caractérisée en ce que** la première marque d'ajustement et/ou la deuxième marque d'ajustement et/ou la troisième marque d'ajustement comprend une protubérance et/ou une rainure.

4. Unité de cellules solaires selon l'une quelconque des revendications précédentes, **caractérisée en ce que** les marques d'ajustement présentent une hauteur de structure d'au moins 0,2 mm, afin de permettre un centrage et une orientation mécaniques.

5. Unité de cellules solaires selon la revendication 3 ou la revendication 4, **caractérisée en ce que** chaque marque d'ajustement comprend exactement une rainure.

6. Unité de cellules solaires selon l'une quelconque des revendications 2 à 5, **caractérisée en ce que** la première marque d'ajustement, l'axe optique et la deuxième marque d'ajustement forment un premier angle et la deuxième marque d'ajustement, l'axe optique et la troisième marque d'ajustement forment un deuxième angle, et le deuxième angle est différent du premier angle.

7. Unité de cellules solaires selon l'une quelconque des revendications précédentes, **caractérisée en ce que** l'angle entre deux marques d'ajustement immédiatement voisines vaut 120° ou 135°, dans laquelle les angles entre des marques d'ajustement sont chaque fois déterminés par rapport à l'axe optique.

8. Unité de cellules solaires selon l'une quelconque des revendications 2 à 6, **caractérisée en ce que** l'angle entre deux marques d'ajustement immédiatement voisines vaut 135° et 90°, dans laquelle les angles entre des marques d'ajustement sont chaque fois mesurés par rapport à l'axe optique.

9. Unité de cellules solaires selon l'une quelconque des revendications précédentes, **caractérisée en ce qu'**il est prévu une troisième face de bord.

10. Unité de cellules solaires selon l'une quelconque des revendications précédentes, **caractérisée en ce que** le rebord forme un bord périphérique et le bord périphérique entoure entièrement sous forme annulaire l'élément optique.

11. Unité de cellules solaires selon l'une quelconque des revendications précédentes, **caractérisée en ce que** les faces de bord forment une face plane continue.

12. Unité de cellules solaires selon l'une quelconque des revendications précédentes, **caractérisée en ce qu'**une couche de colle transparente aux UV est formée entre l'élément optique et la face de réception de la cellule solaire.

13. Procédé de fabrication d'une unité de cellules solaires (10) par un processus d'assemblage avec
- un corps semi-conducteur configuré comme cellule solaire (20) avec une face de réception (24), et
- un support (30) avec un côté supérieur (34) et un côté inférieur (38), dans laquelle le corps semi-conducteur est connecté électriquement et assemblé par adhérence au côté supérieur (34) du support (30), et
- un élément optique secondaire (40), dans lequel l'élément optique présente une surface, et dans lequel une partie de la surface est formée par une face de réception essentiellement convexe et une lumière solaire arrivant sur la face de réception convexe est focalisée au moyen de la face de réception convexe,
**caractérisé en ce que** l'élément optique (40) est entouré par un rebord en forme d'épaulement (50), et le rebord en forme d'épaulement (50) présente une première face de bord et une deuxième face de bord, et dans lequel le vecteur normal de la première face de bord et le vecteur normal de la deuxième face de bord sont essentiellement parallèles à l'axe optique de l'élément optique (40) et les vecteurs normaux sont dirigés à l'inverse de la direction de la lumière solaire incidente (L), et près du rebord en forme d'épaulement (50) une première marque d'ajustement (60; 70) est disposée sur la première face de bord et une deuxième marque d'ajustement (60; 70) est disposée sur la deuxième face de bord, dans lequel la première marque d'ajustement (60; 70) est espacée de la deuxième marque d'ajustement (60; 70), et pendant le processus d'assemblage l'élément optique secondaire (40) est maintenu par une unité de préhension (100), et la position et l'orientation de l'élément optique (40) par rapport à l'unité de préhension (100) sont déterminées par l'emboîtement de l'unité de préhension avec les marques d'ajustement, et
un agent de liaison (80) est déposé sur la face de réception (24) et/ou sur le côté inférieur (44) de l'élément optique (40) et l'élément optique (40) est positionné et orienté par rapport à la face de réception (24) et l'élément optique (40) est maintenu par l'unité de préhension (100) pendant le durcissement de l'agent de liaison (80) à une distance prédéterminée de la face de réception (24) afin de former une fente remplie d'agent de liaison durci (80) entre l'élément optique (40) et la face de réception (24).

14. Procédé selon la revendication 13, **caractérisé en ce que** l'élément optique (40) ou le corps semi-conducteur est maintenu à une température d'au moins 50°C pendant le durcissement de l'agent de liaison (80).

15. Procédé selon les revendications 13 ou 14, **caractérisé en ce qu'**avant le positionnement et l'orientation de l'élément optique secondaire par rapport à la face de réception (24), on détecte la position et l'orientation de la face de réception (24) sur le support (40) avec un système de reconnaissance d'image.
